# EUROPEAN PATENT APPLICATION

(11) **EP 2 704 204 A1**
(43) Date of publication of application: **05.03.2014**
(21) Application number: 13182450.0
(22) Date of filing: 30.08.2013
(51) Int. Cl.: H01L 31/0224, H01L 31/18

(54) **Method and apparatus for printing a pattern on a substrate**

(30) Priority: 31.08.2012 IT UD20120149; 11.01.2013 US 201361751764 P
(71) Applicant: APPLIED MATERIALS ITALIA S.R.L., 31048 San Biagio di Callalta (TV) (IT)
(72) Inventor: Galiazzo, Marco, 35127 Padova (IT); Voltan, Alessandro, 35020 Legnaro (PD) (IT); Casarin, Alessandro, 31055 Quinto di Treviso (TV) (IT)
(74) Representative: Zimmermann & Partner

(57) **Abstract**

The present invention includes a method and apparatus for printing a pattern on a substrate. The method includes acquiring an image of a surface of the substrate having a plurality of print tracks and identifying a position of a print track portion on the plurality of print tracks. The method further includes determining adjustment parameters by comparing the position of the print track portion with a position of a predefined print track, and executing a subsequent printing operation based on the adjustment parameters. The apparatus includes at least one inspection unit and a computer readable medium containing instructions for a processor to execute a method for printing comprising: (i) identifying a position of a print track portion; (ii) determining adjustment parameters by comparing the position of the print track portion with a position of a predefined print track; and (iii) executing a subsequent printing operation based on the adjustment parameters.

## Description

### BACKGROUND OF THE INVENTION

### Field of the Invention

Embodiments of the invention relate to a method and apparatus for printing a conductive material on a substrate, for example with a silicon or alumina base, used to form photovoltaic (PV) cells or green-tape type circuits.

### Description of the Related Art

Solar cells are PV devices that convert sunlight directly into electrical power. One major component in making commercially viable solar cells to make PV devices lies in reducing the manufacturing costs required to form the solar cells by improving the device yield and increasing the substrate throughput. Methods for producing solar cells and configuring solar cells with one or more p-n junctions are well known. Each p-n junction comprises two different regions within a semiconductor material where one side is denoted as the p-type region and the other as the n-type region. When the p-n junction of a solar cell is exposed to sunlight, the sunlight is directly converted to electricity through the PV effect. Solar cells generate a specific amount of electric power and are made and disposed in solar modules sized to deliver the desired amount of system power. Solar modules are joined into panels with specific frames and connectors. Solar cells are commonly formed on silicon substrates, which may be single or multicrystalline silicon substrates. A typical solar cell includes a silicon substrate, or sheet, that is typically less than about 0.3 mm thick with a thin layer of an n-type silicon on top of a p-type region formed on the substrate.

Generally, a standard silicon solar cell is fabricated on a substrate which includes a p-type base region, an n-type emitter region, and a p-n junction region disposed therebetween. An n-type region, or n-type semiconductor, is formed by doping the semiconductor with certain types of elements (e.g. phosphorous (P), arsenic (As) or antimony (Sb)), in order to increase the number of negative charge carriers, i.e. electrons. Similarly, a p-type region, or p-type semiconductor, is formed by the addition of trivalent atoms to the crystal lattice, resulting in a missing electron from one of the four covalent bonds normal for the silicon lattice. Thus the dopant atom can accept an electron from a neighboring atoms covalent bond to complete the fourth bond. The dopant atom accepts an electron, causing the loss of half of one bond from the neighboring atom and resulting in the formation of a "hole."

When light falls on the solar cell, energy from the incident photons generates electron-hole pairs on both sides of the p-n junction region. Electrons diffuse across the p-n junction to a lower energy level, and holes diffuse in the opposite direction, creating a negative charge on the emitter and a corresponding positive charge builds up in the base. When an electrical circuit is made between the emitter and the base, and the p-n junction is exposed to certain wavelengths of light, a current will flow. The electrical current generated by the semiconductor, when illuminated, flows through contacts disposed on the frontside, i.e. the light-receiving side, and the backside of the solar cell. The top contact structure is generally configured as widely-spaced thin metal lines, or fingers, that supply current to larger busbars. The back contact is generally not constrained to be formed in multiple thin metal lines, since it does not prevent incident light from striking solar cells. The solar cell is generally covered with a thin layer of dielectric material, such as Si₃N₄, to act as an antireflection coating, or ARC, to minimize light reflection from the top surface of the solar cell.

Screen printing has long been used in the electronics industry for printing electrical component designs, such as electrical contacts or interconnects, on the surface of a substrate. State of the art solar cell fabrication processes also use screen printing processes. In some applications, it is desirable to screen print contact lines, such as fingers, on the solar cell substrate. The fingers are in contact with the substrate and are able to form an Ohmic connection with one or more doped regions (e.g. n-type emitter region). An Ohmic contact is a region on a semiconductor device that has been prepared so that the current-voltage (I-V) curve of the device is linear and symmetric, i.e., there is no high-resistance interface between the doped silicon region of the semiconductor device and the metal contact. Low resistance, stable contacts are critical for the performance of the solar cells and reliability of the circuits formed in the solar cell fabrication process.

A heavily doped region may be formed on the substrate surface using a variety of patterning techniques to create areas of heavier and lighter doping, for example by performing phosphorous diffusion steps using a patterned diffusion barrier. A backside contact completes the electrical circuit required for a solar cell to produce a current by forming an Ohmic contact with a p-type base region of the substrate. To enhance the contact with the solar cell device it is typical to position a finger on a heavily doped region formed within the substrate surface to enable the formation of an Ohmic contact. Since the formed heavily doped regions, due to their electrical properties, tend to block or minimize the amount of light that can pass therethrough, it is desirable to minimize their size, while also making these regions large enough to assure that the fingers can be reliably aligned and formed thereon.

The formation of heavily doped regions the fingers may include the deposition of multiple layers of material.

The surface area affected by the heavily doped region may be wider than necessary, due to the misalignment of the layers that form the heavily doped region, and therefore, impede the passage of light which would otherwise be available for the solar cell.

Furthermore, a misalignment of the fingers deposited on the underlying heavily doped regions can lead to poor device performance and low device efficiency.

The misalignment in the formation of the heavily doped regions, and of the fingers, may be due to errors in the positioning of the substrate on an automated transferring device, defects in the edge of the substrate, unknown registration and alignment of the heavily doped region on the substrate surface and/or shifting of the substrate on the automated transferring device. Consequently, in the event of an error during a printing process step, the misalignment of the multiple layers printed may cause the substrate to be discarded.

Within this field, it is known to produce solar cells on a crystalline silicon base by means of the screen printing techniques described above, in order to achieve multilayer patterns on the front and/or rear surface of the solar cell. Multilayer patterns are formed, for example by double printing, or by means of several successive printing steps. This may be done by screen printing, laser printing, ink jet printing or other similar processes, on a suitable support or substrate, for example a substrate with a silicon or alumina base. Using multilayer patterns makes it possible to form, for example, solar cells with selective emitters.

Multilayer structures, for example formed by at least a first layer and a second layer on top of the first layer, allow an increase in the current delivered by the contacts, but can make the printing process more complex. In this case, in fact, the multiple layers must be correctly aligned with each other, with a precision that is generally in the range of 10 micron (mm). If the movement of the substrate on an automated transfer device and the movement of a print head are not properly controlled, the pattern deposited will form incorrectly. Consequently, in the event of an error during a printing process step, possible misalignments of the multiple printed layers cause the substrate to be discarded. Therefore, there is a need for one or more control steps after each printing step, to verify the alignment of the layers printed on each occasion with respect to the layers below.

Some known control techniques require the position of the printed layers in order to use this information for a closed-ring retroaction control, or also known as closed-loop control. However, once a given layer has been printed on the layer previously printed, it is particularly difficult to know the exact position since all the layers are overlapping. In this respect, a known method for printing several overlapping layers deposited according to a pattern is able to determine the correct orientation and disposition of the substrate for the subsequent printing operations by detecting the position of suitable markers printed on the substrate. The known method forms suitable markers on the substrate surface, which in some conditions may not be directly visible by the optical acquisition means.

Indeed, substrates on a silicon base are obtained by the fusion of silicon discards, also known as monocast substrates, which as they solidify include zones with a different crystallization configuration, conferring on the print surface a coloring that is not uniform and can be confused with the color of the markers. In this case, the acquisition method described above may not always be effective. Therefore, there is a need to perfect: (i) a method for printing a pattern on a substrate that will allow the correct reciprocal alignment of the printed layers; and (ii) a method that allows for detecting the position of print tracks without providing reference markers.

### SUMMARY OF THE INVENTION

Embodiments of the invention provide a method and apparatus for printing a pattern on a substrate, which can be used to form PV cells or green-tape type circuits. According to one embodiment, a method of printing a pattern on a substrate comprises acquiring an image of a surface area of the substrate having a plurality of print tracks printed thereon and identifying a position of a print track portion on the plurality of print tracks with respect to at least one side of the substrate by means of the image. The method further includes determining adjustment parameters by comparing the position of the print track portion with a position of a predefined print track, and executing a subsequent printing operation based on the adjustment parameters.

In one embodiment, an apparatus for printing a substrate includes at least one inspection unit configured to acquire an image of a surface area of the substrate having a plurality of print tracks printed thereon and a computer readable medium. The computer readable medium contains instructions for a processor to execute a method for printing a pattern on the substrate comprising: (i) identifying a position of a print track portion of the plurality of print tracks with respect to at least one side of the substrate by means of the image; (ii) determining adjustment parameters by comparing the position of the print track portion with a position of a predefined print track; and (iii) executing a subsequent printing operation based on the adjustment parameters.

### BRIEF DESCRIPTION OF THE DRAWINGS

So that the manner in which the above-recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figure 1 is a schematic isometric view of one embodiment of a screen printing system;

Figure 2 is a schematic top plan view of the screen printing system of Figure 1;

Figure 3 is a schematic isometric view of one embodiment of a screen printing system;

Figure 4 is a schematic top plan view of the screen printing system of Figure 3;

Figure 5 is a schematic isometric view of one embodiment of a screen printing system;

Figure 6 is a schematic top plan view of the screen printing system of Figure 5;

Figure 7 is an isometric view of one embodiment of a printing nest;

Figure 8 is a schematic isometric view of one embodiment of an inspection assembly;

Figure 9 is a schematic representation of a substrate on which print tracks are printed in a pattern;

Figure 10 is a schematic representation of a reference print pattern;

Figure 11 is a schematic representation of the comparison between Figure 9 and Figure 10;

Figure 12 shows a variant of Figure 8;

Figure 13 is a schematic representation of a substrate on which print tracks are printed in a pattern according to another embodiment;

Figure 14 is a plan schematic representation of a substrate on which the print tracks are printed and to which a method for printing a pattern on a substrate is applied.

Figure 15 is a schematic representation of a portion of a substrate on which print tracks are printed in a pattern according to an embodiment described herein;

Figure 16 is a schematic representation of a portion of the substrate shown in Figure 15 according to an embodiment described herein; and

Figure 17 is a schematic representation of a portion of a substrate on which print tracks are printed in a pattern according to a further embodiment described herein.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

Embodiments of the invention provide a method and an apparatus for printing a pattern on a substrate which can be applied using a screen printing system to form metal contacts in a desired pattern on a surface of a substrate of a solar cell.

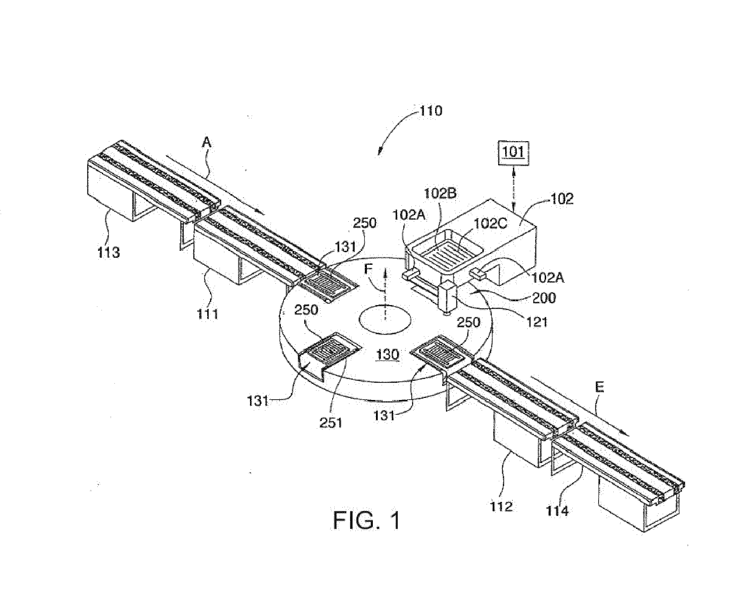

In one embodiment, as seen in Figure 1, a screen printing system 110 comprises an incoming conveyor 111, a rotary actuator assembly 130, a screen printing chamber 102, and an outgoing conveyor 112. The incoming conveyor 111 may be configured to receive a substrate 250 from an input device, such as an input conveyor 113 (i.e., path "A"), and transfer the substrate 250 to a printing nest 131 coupled to the rotary actuator assembly 130. The outgoing conveyor 112 may be configured to receive the processed substrate 250 from the printing nest 131 coupled to the rotary actuator assembly 130 and transfer the substrate 250 to a substrate removal device, such as an exit conveyor 114 (i.e., path "E"). The input conveyor 113 and the exit conveyor 114 may be automated substrate handling devices that are part of a larger production line.

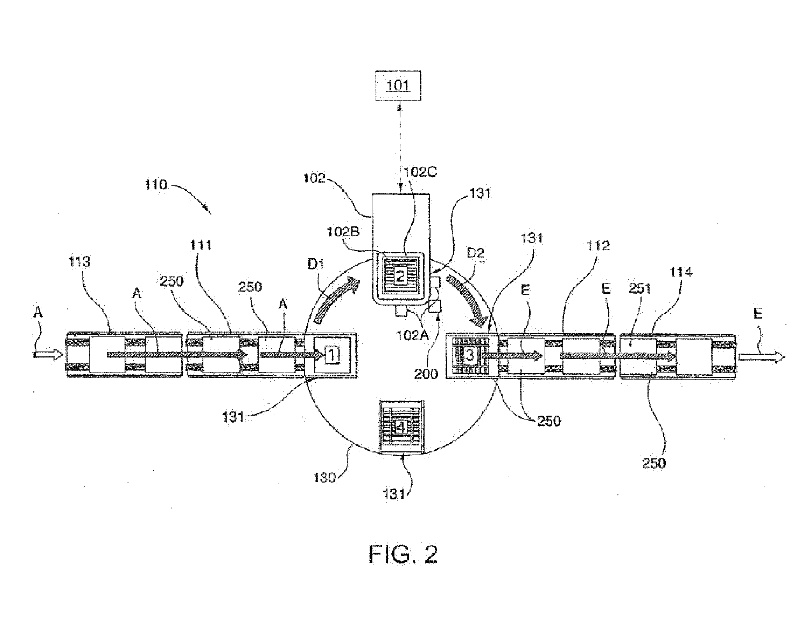

In one embodiment, the rotary actuator assembly 130 may be rotated and angularly positioned about the "F" axis by a rotary actuator (not shown) and a system controller 101, such that the printing nests 131 may be selectively angularly positioned within the screen printing system 110 (i.e., paths "D1" and "D2" as seen in Figure 2). The rotary actuator assembly 130 may also have one or more supporting components to facilitate the control of the printing nests 131 or other automated devices used to perform a substrate processing sequence in the screen printing system 110.

In one embodiment, as seen in Figures 1 and 2, the rotary actuator assembly 130 includes four printing nests 131, or substrate supports, that are each adapted to support substrate 250 during the screen printing process performed within the screen printing chamber 102. Figure 2 schematically illustrates the position of the rotary actuator assembly 130 in which: (i) one printing nest 131 is configured in position "1" to receive a substrate 250 from the incoming conveyor 111; (ii) another printing nest 131 is configured in position "2" within the screen printing chamber 102 so that another substrate 250 can receive a screen printed pattern on a surface 251 thereof; (iii) another printing nest 131 is configured in position "3" for transferring a processed substrate 250 to the outgoing conveyor 112; and (iv) another printing nest 131 is configured in position "4", which is an intermediate stage between position "1" and position "3."

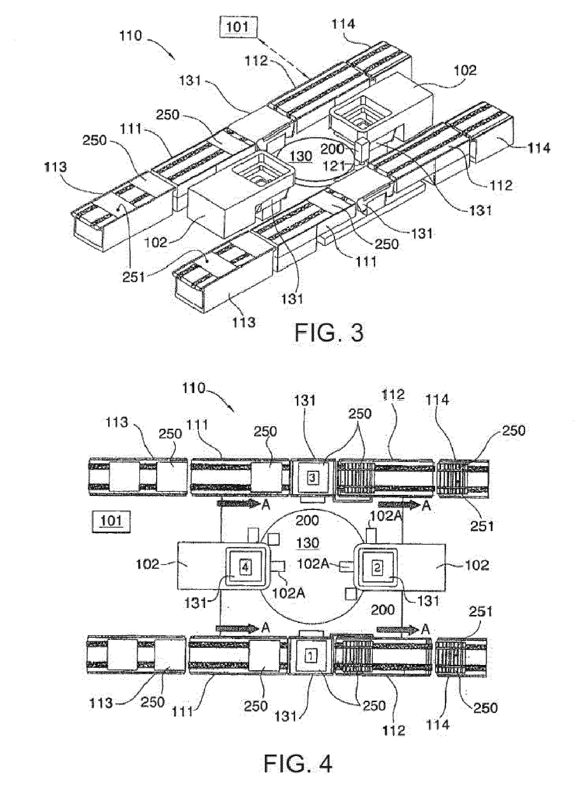

Figure 3 is an isometric view of another embodiment of a screen printing system 110, and Figure 4 is a top plan of the screen printing system 110 of Figure 3 , that can also be used in conjunction with embodiments of the present invention to form the metal contacts according to a desired pattern on a surface 251 of the solar cell substrate 250.

In one embodiment, the screen printing system 110 of Figures 3 and 4 comprises two incoming conveyors 111 and the actuator assembly 130 is configured as a rotary table or rotary actuator. The screen printing system 110 also includes a plurality of printing nests 131, a plurality of screen printing chambers 102, two outgoing conveyors 112, and the system controller 101. The incoming conveyors 111 are configured in a parallel processing orientation so that each can receive unprocessed substrates 250 from an input device, such as the input conveyor 113, and transfer each unprocessed substrate 250 to the printing nest 131 coupled to the actuator assembly 130. In addition, the outgoing conveyors 112 are configured in a parallel orientation so that each outgoing conveyor 112 can receive a processed substrate 250 from the printing nest 131 and transfer each processed substrate 250 to a substrate removal device, such as the exit conveyor 114.

In one embodiment, the screen printing system 110 in Figures 3 and 4 has two printing nests 131 (in positions "1" and "3" as seen in Figure 4) each positioned to both transfer processed substrate 250 to the outgoing conveyor 112 and to also receive non-processed substrate 250 from the incoming conveyor 111.

Thus, in the screen printing system 110 in Figures 3 and 4, the movement of the substrate generally follows the path "A" (Figure 4). In this configuration, each of the two other printing nests 131 (in positions "2" and "4") is positioned under the screen printing chamber 102, so that screen printing can be carried out on the non-processed substrates 250 located on the respective printing nests 131.

This parallel processing configuration allows for an increased productive capacity with minimum bulk in the processing system. Although the screen printing system 110 is illustrated in Figures 3 and 4 with two screen printing chambers 102 and four printing nests 131, the screen printing system 110 can include additional screen printing chambers 102 and/or printing nests 131, without departing from the field of the present invention.

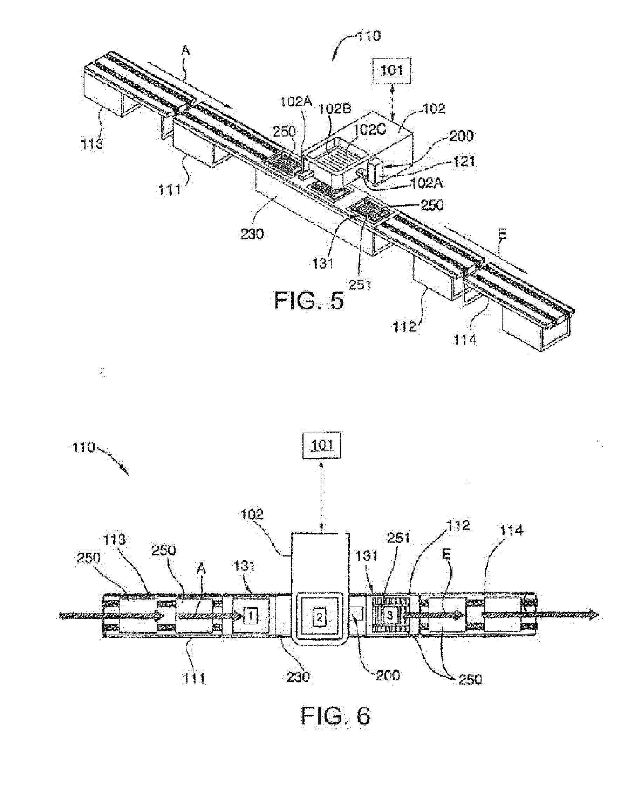

Figure 5 is an isometric view of another embodiment of a screen printing system 110, and Figure 6 is a top plan view of the screen printing system 110, which can also be used in conjunction with embodiments of the present invention to form the metal contacts in a desired pattern on surface 251 of the solar cell substrate 250. In one embodiment, the screen printing system 110 of Figures 5 and 6 comprises the incoming conveyor 111, an actuator unit 230, which in one embodiment is configured as a linear movement unit, a screen printing chamber 102, the outgoing conveyor 112 and the system controller 101.

The incoming conveyor 111 can be configured to receive substrate 250 from an input device, such as input conveyor 113 (i.e., path "A" in Figures 5 and 6), and transfer the substrate 250 to the printing nest 131 coupled at an inlet of the linear movement unit 230. The outgoing conveyor 112 can be configured to receive a processed substrate 250 from the printing nest 131 coupled at an exit of the linear movement unit 230 and transfer the substrate 250 to a substrate removal device, such as exit conveyor 114 (i.e., path "E" in Figures 5 and 6). As mentioned above, the input conveyor 113 and the exit conveyor 114 may be automated substrate handling devices that are part of a larger production line.

The incoming conveyor 111 transports the substrates 250 from: (i) a first position "1" as seen in Figure 6, in which the substrate 250 is introduced into the screen printing chamber 102; (ii) a second position "2" inside the screen printing chamber 102; and (iii) a third position "3" in which the processed substrate 250 is discharged from the screen printing chamber 102 and conveyed to other operating stations. In the case of a double or multiple printing, the substrate 250 is again introduced into the screen printing chamber 102 in position "2" to carry out a second or further printing step and is then discharged again from the screen printing chamber 102 passing to position "3." This alternate movement is repeated a desired number of times to coordinate with the number of layers to be printed, until the final product is definitively discharged. One skilled in the art will appreciate that the process of double or multiple layer printing can also be performed in one of the configurations shown in Figures 1-4 in a similar fashion.

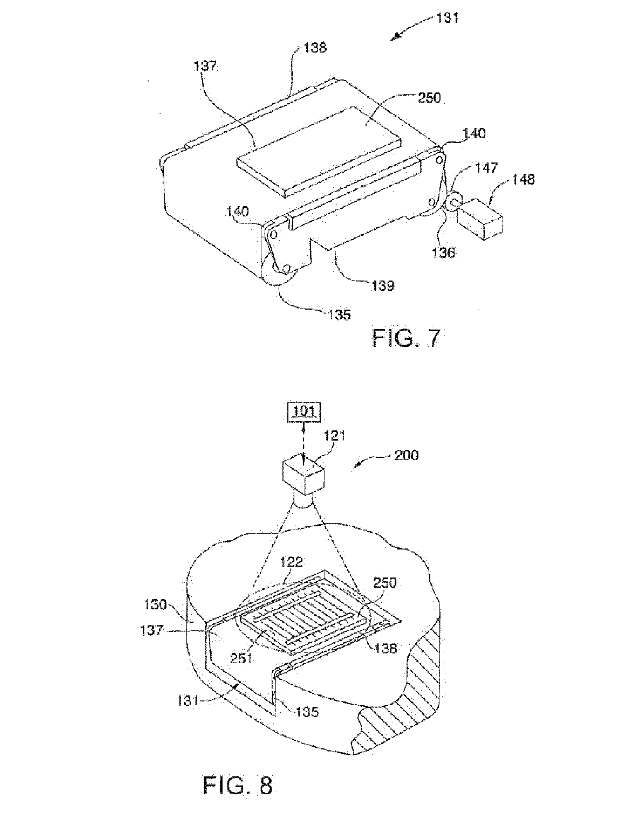

Referring to Figure 7, printing nest 131 generally consists of a conveyor assembly 139 that has a feed spool 135, a take-up spool 136, rollers 140 and one or more actuators 148. The actuators 148 are coupled to the feed spool 135 and/or take-up spool 136, that are adapted to feed and retain a supporting material 137 positioned across a platen 138. The platen 138 generally has a substrate supporting surface on which the substrate 250 and supporting material 137 are positioned during the screen printing process performed in the screen printing chamber 102. In one embodiment, the supporting material 137 is a porous material that allows substrate 250, which is disposed on one side of the supporting material 137, to be retained on the platen 138 by a vacuum applied to the opposing side of the supporting material 137 by a conventional vacuum generating device (e.g., vacuum pump, vacuum ejector).

In one embodiment, a vacuum is applied to vacuum ports (not shown) formed in the substrate supporting surface of the platen 138 so that the substrate can be "chucked" to the substrate supporting surface of the platen 138. In one embodiment, the supporting material 137 is a porous material, permeable to air, that consists, for instance, of a porous paper, permeable to air, of the type used for cigarettes or another analogous material, such as a plastic or textile material that performs the same function.

In one configuration, the actuators 148 are coupled to, or are adapted to engage with, the feed spool 135 and the take-up spool 136 so that the movement of substrate 250 positioned on the supporting material 137 can be accurately controlled within the printing nest 131. In one embodiment, feed spool 135 and take-up spool 136 are each adapted to receive opposing ends of a length of the supporting material 137. In one embodiment, the actuators 148 each contain one or more drive wheels 147 that are coupled to, or in contact with, the surface of the supporting material 137 positioned on the feed spool 135 and/or the take-up spool 136 to control the motion and position of the supporting material 137 across the platen 138.

Referring to Figures 1-6 each of the screen printing chambers 102 described with the screen printing systems 110 is adapted to deposit material in a desired pattern on the surface 251 of a substrate 250 positioned on the printing nest 131 in position "2" during the screen printing process.

In one embodiment, the screen printing chamber 102 includes a plurality of actuators, for example, actuators 102A (e.g., stepper motors or servomotors) that are in communication with the system controller 101. The actuators 102A are used to adjust the position and/or angular orientation of the screen printing mask 102B as seen in Figures 1 and 5 disposed within the screen printing chamber 102 with respect to the substrate 250 being printed. In one embodiment, the screen printing mask 102B is a metal sheet or plate with a plurality of distinctive features 102C as seen in Figures 2 and 5, such as holes, slots, or other apertures formed therethrough to define a pattern and placement of screen printed material (i.e., ink or paste) on surface 251 of the substrate 250. In general, the screen printed pattern that is to be deposited on the surface 251 of the substrate 250 is aligned to the substrate 250 in an automated fashion by orienting the screen printing mask 102B in a desired position over the substrate surface using the actuators 102A and information received by the system controller 101 from an inspection assembly 200 as seen in Figure 8.

In one embodiment, the screen printing chamber 102 is adapted to deposit a metal containing, dopant containing and/or dielectric containing material on a solar cell substrate having a width between about 125 mm and 156 mm and a length between about 70 mm and about 156 mm.

In one embodiment, the screen printing chamber 102 is adapted to deposit a metal containing paste on the surface 251 of the substrate to form the metal contact structure on a surface of a substrate.

The inspection assembly 200 is associated with each of the screen printing systems 110 shown in Figures 1-6 and adapted to inspect substrate 250 disposed on the printing nest 131 on which the desired pattern is printed by means of screen printing.

Referring to Figure 8, the inspection assembly 200 is adapted to identify and inspect the substrates 250 before and after printing and may comprise one or more cameras 121 (e.g., CCD camera) and electronic components capable of inspecting and communicating the inspection results to the system controller 101 used to analyze the orientation and position of the substrate 250 on the printing nest 131.

In one embodiment, the camera 121 is positioned over the surface 251 of the substrate 250 so that a viewing area 122 of the camera 121 can inspect at least one part or region of the surface 251. As described above, the information received by the camera 121 is used both to align the screen printing mask 102B and thus the subsequently deposited material, and also to acquire an image of the layer deposited on the substrate 250.

In one embodiment, the camera 121 is an InGaAs type camera that has a cooled CCD array to enhance the signal-to-noise ratio of the detect signal. In other embodiments, it is desirable to isolate the inspection assembly 200 from ambient light by enclosing or shielding the areas between the surface 251 of the substrate 250 and the camera 121.

In one embodiment, the inspection assembly 200 also includes one or more optical filters (not shown) that are disposed between the camera 121 and the surface of the substrate 250. In this embodiment, the optical filter(s) is/are selected to allow only certain desired wavelengths to pass to the camera 121 to reduce the amount of unwanted energy being received by the camera 121 to improve the signal-to-noise ratio of the detected radiation. The optical filter(s) can be a bandpass filter, a narrowband filter, an optical edge filter, a notch filter, or a wideband filter purchased from, for example, Barr Associates, Inc. or from Andover Corporation.

The system controller 101 facilitates the control and automation of the overall screen printing system 110 and may include a central processing unit (CPU) (not shown), memory (not shown), and support circuits (or I/O) (not shown). The CPU may be one of any form of computer processors that are used in industrial settings for controlling various chamber processes and hardware (e.g., conveyors, optical inspection assemblies, motors, fluid delivery hardware, etc.) and monitor the system and chamber processes (e.g., substrate position, process time, detector signal, etc.). The memory is connected to the CPU, and may be one or more of a readily available memory, such as random access memory (RAM), read only memory (ROM), floppy disk, hard disk, mass memory or any other form of digital storage, local or remote. Software instructions and data can be coded and stored within the memory for instructing the CPU. The support circuits are also connected to the CPU for supporting the processor in a conventional manner. The support circuits may include cache, power supplies, clock circuits, input/output circuitry, subsystems, and the like. A program (or computer instructions) readable by the system controller 101 determines which tasks are performable on a substrate. In some embodiments, the program is software readable by the system controller 101. The system controller 101 includes code to generate and store at least substrate positional information, the sequence of movement of the various controlled components, substrate optical inspection system information, and any other corresponding combination.

In one embodiment, the printing methods described herein contain a program (or computer instructions) readable by the system controller 101 for determining the execution of the printing methods by means of the screen printing system 110.

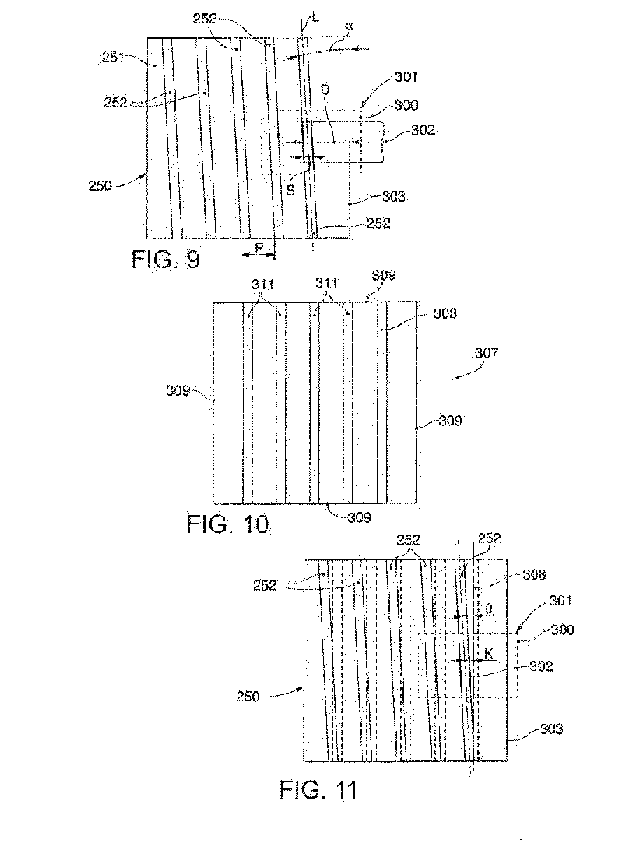

Embodiments of the present invention provide a method for printing a pattern on substrate 250 during which a plurality of print tracks 252 are printed according to a pattern on the surface 251 of the substrate 250, as seen in Figure 9.

The print tracks 252 are disposed parallel to each other and have a thickness S. In one embodiment, the thickness S is between about 50 mm and about 500 mm, and the print tracks 252 have a pitch P of some millimeters apart from each other.

In one embodiment, the print tracks 252 are thin metal lines, or fingers, widely spaced, that are configured to supply current to collector bars, which are wider than the fingers, in the solar cell substrate 250. In one embodiment, substrate 250 has a plurality of print tracks 252 printed with a rectilinear configuration or orientation. The plurality of print tracks 252 are substantially parallel to each other and respectively parallel to two opposite edges of the substrate 250.

In one embodiment, a method for printing a pattern on a substrate includes acquiring at least one image 301 (Figure 9) of at least a surface area 300 of a portion of the overall print surface 251 of the substrate 250. In one embodiment, the image 301 is acquired optically, for example, by means of the camera 121 described above and includes digital information relating to features of the area viewed by the camera 121. In one embodiment, the image 301 is a photograph of the surface area 300 on which the print tracks 252 are deposited. In yet another embodiment, the image 301 is a photograph or digital image of the surface of the substrate that contains shades of gray.

The acquisition of the image 301 is made in such a way that the surface area 300 includes at least some of the print tracks 252, in this case two print tracks 252, that are printed on the substrate 250. With each print track 252 present in the image 301, it is possible to identify at least one print portion 302 of the surface area 300. Print portion 302, as described herein, is an identifiable segment of the print track 252 in the image 301 that extends for a length less than the overall length of the entire track of image 301.

In one embodiment, the print portion 302 is optically visible with respect to the surface 251 of the substrate 250 on which it is printed, and in particular with respect to the remaining part of the print track 252 to which it belongs. The expression "optically visible," as described herein, means that the print portions 302 have contrasting color shades that are distinguishable from those on the surface 251 of the substrate 250 on which the print tracks 252 are deposited.

As shown in Figures 9 and 11, a single print portion 302 has been considered, although in other embodiments it may be provided to identify two or more print portions 302 to help identify the orientation of the print tracks. In other embodiments, it may be provided to identify the image 301 as a statistical combination of several print portions 302, belonging to the same print track or to several print tracks 252.

In one embodiment, a position of the print portion 302, with respect to at least a side 303 of the substrate 250, is identified. Side 303, as defined herein, is a segment of a perimeter of the surface 251 of the substrate 250 on which the print tracks 252 are printed. In the embodiment shown in Figure 9, the side 303 develops substantially parallel to the main longitudinal extension of the print tracks 252 that have been made on the substrate 250. Other embodiments of a method of printing assess the position of the print portion 302 with respect to two opposite edges of the substrate 250. This allows for greater precision in detecting the position of print portion 302.

The image 301 acquired by the camera 121 does not necessarily have to detect side 303. In fact, knowing the position of where the camera 121 is mounted in the inspection assembly 200, and the position of the printing nest 131 on which the substrate 250 is positioned, it is possible to identify the position of the image 301 with respect to the side 303. In one embodiment, the method of printing provides that the position of the print portion 302 is assessed by a processor, or the system controller 101.

In one embodiment, the assessment of the position of the print portion 302 divides the image 301 into a plurality of elementary units, or pixels. In one embodiment, in order to identify the position of the print portion 302, the print portion 302 has a length that is equal to at least two elementary units or pixels into which the acquired image 301 is divided in order to easily identify the position of the print portion 302. The elementary units may have a length between about 100 mm and about 150 mm.

By dividing the image 301 into elementary units, zones of the image 301 can be split into units that refer to the print portion 302 that are on the surface 251 and units of the print portion 302 that are not present on the surface 251. In one embodiment, the splitting includes assessing the chromatic differences, or shades of gray, of the print portion 302 with respect to the rest of the image 301. In some embodiments, the print portion 302 has a lighter shade of gray than the rest of the image 301, due to a difference in the optical characteristics of this area of the substrate.

In accordance with one embodiment, determining a first distance D and an angle of orientation α with respect to the side 303 of the substrate 250 identifies the position of the print portion 302. In one embodiment, the first distance D and the angle of orientation α are assessed with respect to a median line L (Figure 9) of the thickness of the print portion 302. In another embodiment, the first distance D and the angle of orientation α are assessed with respect to a perimeter side of the thickness of the print portion 302. One embodiment provides that once the position of the print portion 302 has been identified, it is compared with a position of a predefined print track 308 (Figures 10 and 11), which is stored in the memory of the system controller 101. More specifically, the predefined print track 308 defines the optimum positioning that the print portion 302, and hence the whole print track 252 on the surface 251 of the substrate 250 to which it belongs, and hence also the print track 252's position with respect to the side 303. In embodiments herein, the predefined print track belongs to a predefined deposition pattern with respect to the substrate.

In accordance with one embodiment, the above described comparison is carried out considering a predefined reference pattern 307, as seen in Figure 10, which includes the predefined print track 308. In the embodiment shown in Figure 10, the reference pattern 307 also includes other predefined print tracks 311 which together with the predefined print tracks 308, reproduce a model print pattern with which substrate 250 coordinates. The reference pattern 307, for example, can be preloaded in the memory of the system controller 101.

The reference pattern 307 has peripheral edges 309, which during the comparison, described above, perfectly overlap with the respective peripheral edges of the substrate 250, and in particular one of them with the side 303. In this manner, there is precise and complete overlapping of the reference pattern 307 as defined with the surface 251 of the substrate 250.

One of the sides 309 of the reference pattern 307 and the side 303 of the substrate 250 overlap to function as a common reference system, so that it is possible to directly compare the predefined print track 308 with the print portion 302 identified in the image 301. Therefore, knowing the print pattern of the print tracks 252, and the position of the print portion 302 with respect to the side 303 of the substrate 250, it is possible to determine which print tracks 252 to which the print portion 302 belongs with respect to the predefined print track 308.

Some embodiments of the invention provide that determining the print track 252 to which the print portion 302 belongs occurs when considering the first distance D and the angle of orientation α as previously identified. Furthermore, possible deviations of the print tracks 252 with respect to the reference pattern 307 are not large enough so as to confuse the position of one print track 252 with the adjacent one(s).

During the above described comparison, if the predefined print track 308 overlaps with the print tracks 252, even partly, then the print portion 302 is considered. In this condition it is therefore possible to assess first deviations of the print portion 302 with respect to the predefined print track 308. In other embodiments, the first deviations may comprise the detection of a misalignment "K" and an angular stagger θ between the print portion 302 and the predefined print track 308.

In some embodiments, after the above described comparison, the position of all, or at least some, of the print tracks 252 which are printed on the substrate 250 are assessed based on the position of the print track portion 302. In other embodiments, the processor, or system controller 101, is also able to find a deposition pattern according to which the other print tracks 252, not belonging to the print portion 302, have been printed based on the comparison of the image 301 with the reference pattern 307 and once the misalignment K and the angular stagger θ. Furthermore, given the fixed geometry of the screen printing mask 102B, the print tracks 252 are printed equidistant from each other and with the same orientation from each other.

In some embodiments, assessing the position of all, or at least some, of the print tracks 252 on the substrate 250, based on the position of the print track portion 302, includes extrapolating, or reconstructing, the whole deposition pattern of the print tracks 252 on the substrate 250. Extrapolation or reconstructing includes deriving or estimating the whole deposition pattern on the basis of the local position of the print track portion 302 and of the comparison with the reference pattern 307. The whole deposition pattern is thus inferred from the known local data of the print track portion 302, based on the reference pattern 307, and the predefined print track 308 included therein. From this comparison it is also possible to determine adjustment parameters to be attributed to the screen printing chamber 102 for the subsequent deposition of patterned print tracks.

The adjustment parameters may be the same misalignment K and angular stagger θ values as previously detected, or they can be values suitably modified based on the former, and correlated to the configuration of possible adjustment apparatuses in the screen printing chamber and/or screen printing system. In some embodiments, the adjustment parameters can be used to modify suitable printing parameters needed to carry out the subsequent printing operations, to obtain a correct alignment of the subsequent printing with the already deposited print tracks 252.

Some embodiments provide that determining the printing parameters is defined based on the first deviations as described above. In other embodiments, it is provided that the adjustment parameters allow for modifying the position of the screen-printing mask 102B, so as to dispose its distinctive elements 102C substantially aligned with the already deposited print tracks 252. Other embodiments provide that the adjustment parameters allow for determining possible actions to reposition the substrate 250 on the printing nest 131, in order to define the correct alignment of the print tracks 252 and the distinctive elements 102C of the screen-printing mask 102B.

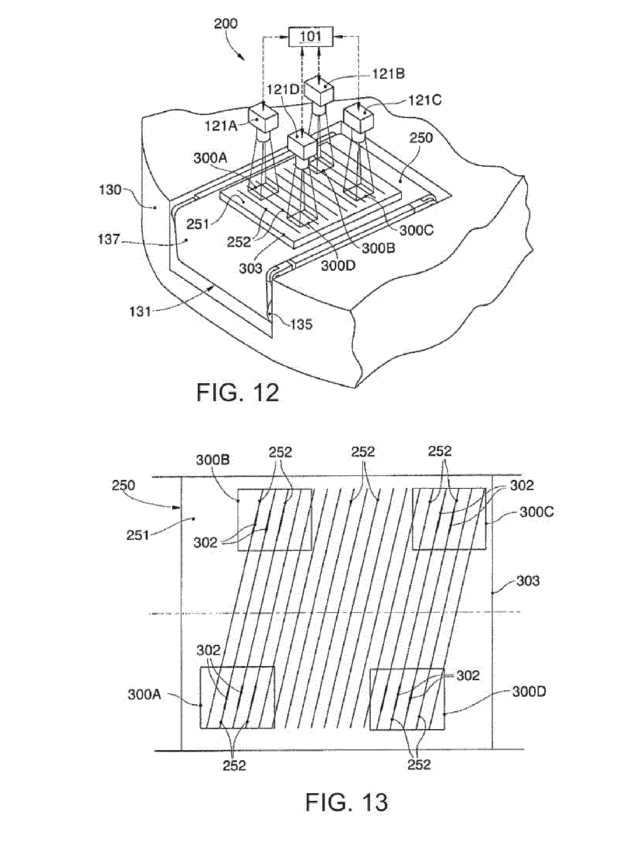

In one embodiment, as shown in Figure 12, the inspection unit 200 comprises four cameras, respectively 121A, 121B, 121C and 121D, each of which is installed above printing nest 131 to acquire an image of a respective surface area, respectively 300A, 300B, 300C, 300D of the surface 251 of the substrate 250. In this embodiment, the four cameras 121A, 121B, 121C and 121D (Figure 13) are configured to acquire images of four surface areas disposed in the vicinity of four tops of the substrate 250. In each of the four surface areas 300A, 300B, 300C and 300D there are a plurality of print tracks 252 and for each of the print tracks 252 their position is determined with the methods as described above.

Using a plurality of surface areas 300A, 300B, 300C and 300D obtains a greater accuracy in reconstructing the pattern of the print tracks 252 already printed. Moreover, it is possible to correlate more information arriving from several print tracks 252 and to obtain a reconstruction with better resolution of all the other print tracks 252. This is particularly effective if there is a need to control the printing position of monocast type substrates 250, or a substrate obtained from the fusion of silicon discards, also known as a monocast silicon substrate.

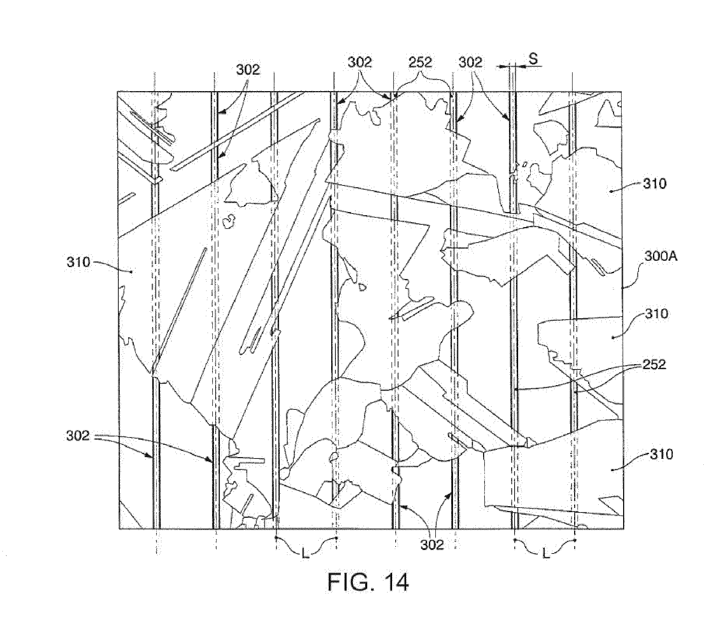

In one embodiment, substrate 250, as shown in Figure 14, is obtained from the fusion of silicon discards. Due to an optical and spatial differentiation in the ways in which the silicon they are made from crystallizes, the substrate 250 has a plurality of surface zones 310 with varying shades of color, very close to those of the formed and identified print tracks 252. Figure 14 shows schematically the acquired image relating to surface area 300A even if, quite obviously, images similar to what is shown in Figure 14 are also acquired for surface areas 300B, 300C, 300D. For these types of substrates 250, some of the surface zones 310 have colors that can be confused with those of the print tracks 252 and are therefore difficult to identify by analyzing the images acquired. With reference to Figure 14, the print portions 302 are visible from the image acquired and are shown in a continuous line, while the non-visible portions are shown with a line of dashes.

Therefore, from the images acquired by the cameras 121A, 121B, 121C and 121D it may not be possible to identify with reasonable certainty the position and orientation of all the print tracks 252 printed on the substrate 250. For this reason, once at least one print portion 302 of at least one print track 252 has been identified in at least one of the four surface areas 300A, 300B, 300C and 300D, it is possible to apply the method as described above, to determine the overall development of both of the print tracks to which the print portion 302 belongs, and also of the other print tracks 252 not taken into consideration.

In some embodiments, the position of the print tracks 252 is identified based on the position of a print portion 302. Print portion 302 is optically visible and identifiable with respect to the surface of the substrate 250, common to print tracks 252, and not by means of other reference elements or markers which in some cases could be confused with the surface of the substrate 250.

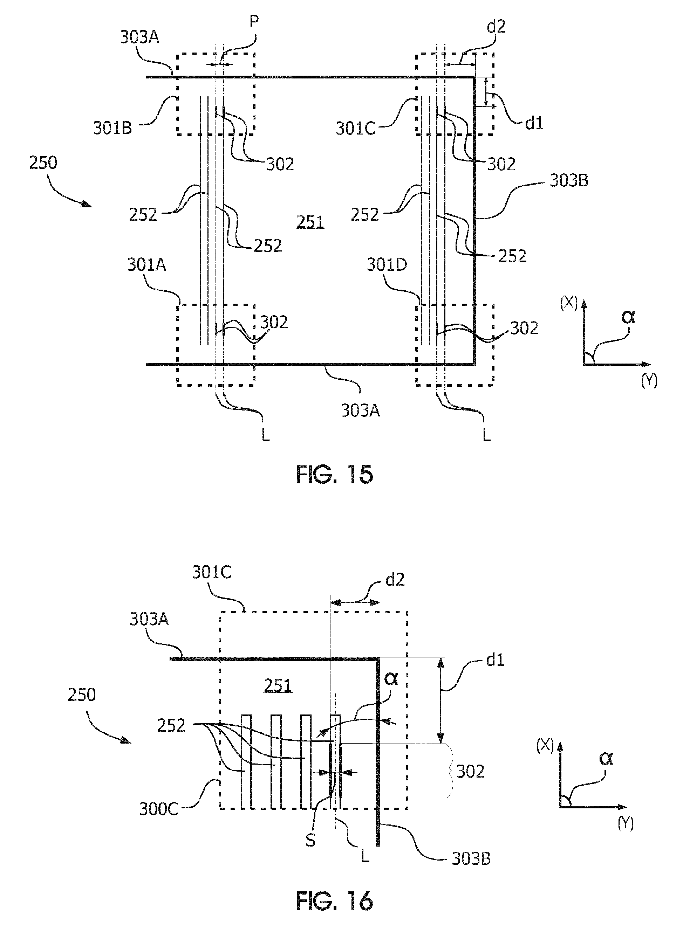

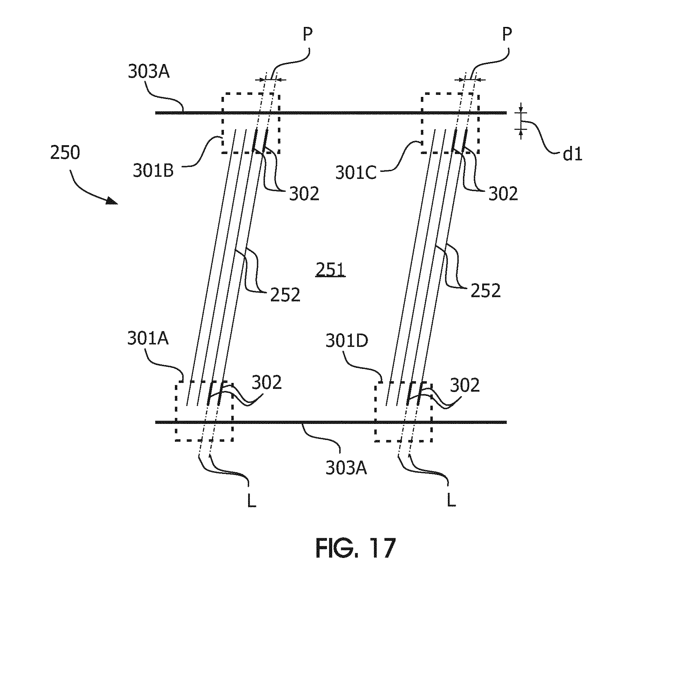

In some embodiment, as shown in Figure 15 and 17, a plurality of images 301A, 301B, 301C, 301D of different areas of a surface of the substrate 250 (i.e. images of a plurality of the surface areas) may be acquired via, for example, an inspection unit as described with respect to Figure 12. The print tracks 252, shown in Figures 15 through 17 are disposed parallel to each other and have a thickness S. In one embodiment, the thickness S is between about 50 mm and about 500 mm, and the print tracks 252 have a pitch P of some millimeters apart from each other.

In embodiments described herein, the print tracks 252 are thin metal lines, or fingers, widely spaced, that are configured to supply current to collector bars, which are wider than the fingers, in the solar cell substrate 250. In one embodiment, substrate 250 has a plurality of print tracks 252 printed with a rectilinear configuration or orientation. The plurality of print tracks 252 are substantially parallel to each other and respectively parallel to two opposite edges of the substrate 250 (e.g. see Figure 15 and 16). In further embodiments herein, the plurality of print tracks may be positioned at an angle anywhere from 0° to 90° with respect to at least one side edge of the substrate (e.g. see Figure 17).

The position of the print tracks 252 is identified based on the position of at least one print portion 302 in at least one image of the surface 251 of the substrate 250. The terms print portion and print track portion, referring to the same feature, are used interchangeably herein. As shown in Figure 15, acquiring respective images of a plurality of the surface areas 301A, 301B, 301C, 301D may increase the accuracy and resolution for reconstructing or extrapolating the pattern of print tracks 252 already printed.

In embodiments described herein, the position of the print portion 302, which may extend less than the overall length of the entire print track of the image, may be determined based on the distances from at least one side edge 303A, 303B of the substrate 250. The side edges 303A and 303B may be perpendicular with respect to one another. As shown in Figures 15 and 16, the distance between side edge 303A of the substrate 250 and the print portion 302 of a print track 252 is denoted as d1. Distance d1 may be described as the distance between a side edge of the substrate and the print portion, which is in axial direction L of the print track. The side edge 303A may be perpendicular with respect to the axial direction L of the print track 252.

The distance between side edge 303B of the substrate 250 and the print portion 302 of a print track 252 is denoted as d2. Distance d2 may also be described as the distance between a side edge of the substrate and the print portion, which is perpendicular to the axial direction of the print track. The side edge 303B may be parallel with respect to the axial direction L of the print track 252.

The assessment of the position of the print portion 302 may be based on the acquired distances d1 and/or d2 as described above. Measuring the angle of orientation (α) of the print portion 302 may increase the accuracy for determining the position of the print track(s). The angle of orientation may be described as the angle of the print portion with respect to at least one of the side edges of the substrate. According to embodiments herein, the angle of orientation (α) may also be determined with respect to a reference line that is perpendicular to at least one of the side edges of the substrate. This reference line may be computed by the system controller and used to establish the angle of orientation (α) of the print portion in embodiments where the print portion is neither parallel nor perpendicular to any of the side edges of the substrate (e.g. see Figure 17).

In embodiments herein, determining a first distance d1 and/or a second distance d2, and an angle of orientation (α) with respect to at least one side edge 303A, 303B of the substrate 250 identifies the position of the print portion 302. According to an embodiment, the first distance d1 and/or a second distance d2, and the angle of orientation (α) may be assessed with respect to a median line L of the thickness of the print portion 302. In another embodiment, the first distance d1 and/or a second distance d2, and the angle of orientation (α) may be assessed in relation to a perimeter side of the thickness of the print portion 302.

One embodiment provides that once the position of the print portion has been identified, it is compared with a position of a predefined print track (e.g. see Figures 10 and 11), which is stored in the memory of a system controller. More specifically, the predefined print track defines the optimum positioning of the print portion, and hence the whole print track on the surface of the substrate to which it belongs, and hence also the print track's position with respect to at least one of the sides edges of the substrate. The comparison with a predefined print track is carried out in a manner as described above with respect to Figures 9 through 11.

In brief, a reference pattern based on at least one predefined print track is coordinated with the surface of the substrate in the acquired image. One of the sides of the substrate in the reference pattern overlaps with the side of the substrate in the acquired image to function as a common reference system, so that it is possible to directly compare the predefined print track with the print portion identified in the acquired image. During this comparison first deviations of the print portion with respect to the predefined print track are assessed, which may comprise misalignment "K" and angular stagger θ between the print portion and the predefined print track. From this comparison it is also possible to determine adjustment parameters to be attributed to the screen printing chamber for the subsequent deposition of patterned print tracks.

In embodiments described herein, the position of a single print portion may be used to identify the position of a plurality of print tracks on a substrate. In further embodiments, it may be provided to identify two or more print portions spaced apart from each other in a single print track to identify the position of the print tracks more accurately. In other embodiments, it may be provided to identify the position of a print track as a statistical combination of several print portions belonging to the same print track or belonging to two or more separate print tracks.

Returning to Figure 15 and 16, according to embodiments herein, the position of at least one print portion 302 of a print track 252 or of two or more print tracks may be determined as described above and used to determine adjustment parameters that may modify suitable printing parameters needed to carry out subsequent printing operations to obtain a correct alignment of the subsequent printing with the already deposited tracks 252. Hence, it is possible to position a second (third or more) print track accurately on top of the already deposited track(s) 252. The high degree of alignment between at least a second print track deposited on top of a first print track using the above-mentioned deposition method ensures a high device performance and efficiency by minimizing errors such as misalignment of multiple layers printed, which also reduces manufacturing costs as less substrate is discarded.

According to an embodiment, the method for printing a pattern on a substrate includes the following steps: acquiring an image of at least one surface area of a substrate having a plurality of print tracks printed thereon; identifying a position of a print track portion on the plurality of print tracks with respect to at least one side of the substrate by means of the acquired image, wherein the at least one side of the substrate is perpendicular to the longitudinal axis of the print track portion; determining adjustment parameters by comparing the position of the print track portion with a position of a predefined print track; and executing a subsequent printing operation based on the adjustment parameters. According to embodiments herein, the predefined print track may be a previously deposited print track or a print track deposited on a previously processed substrate.

In accordance with one embodiment, the above-described comparison of the position of the print track portion with a position of a predefined print track may be carried out with respect to a predefined print track including a predefined reference pattern in a similar fashion as summarized above and described with respect to Figure 10.

Similar to the comparison described with respect to Figures 9 to 11, if the predefined print track overlaps with the print tracks, even partly, then the print portion is considered. In this condition it is therefore possible to assess first deviations of the print portion with respect to the predefined print track. In other embodiments, the first deviations may include the detection of a misalignment (K) and an angular stagger θ between the print portion and the predefined print track.

In further embodiments described herein, the above-mentioned comparison of the position of the print track portion with a position of a predefined print track may be carried out with respect to an image of a previously deposited print track or a print track deposited on a previously processed substrate instead of a predefined print track. The comparison may then be performed in a similar fashion as described with respect to Figure 10, except that the predefined print track will be a previously deposited print track or a print track deposited on a previously processed substrate. If the image of the previously deposited print track or a print track deposited on a previously processed substrate overlaps with the deposited print tracks, even partly, then the print portion is considered. In this condition it is therefore possible to assess first deviations of the print portion with respect to the previously deposited print track or the print track deposited on a previously processed substrate. In other embodiments, the first deviations may include the detection of a misalignment (K) and an angular stagger (θ) between the print portion and the previously deposited print track or the print track deposited on a previously processed substrate.

From both of these comparisons it is possible to determine adjustment parameters to be attributed to the screen printing chamber 102 (see Figure 1) for the subsequent deposition of patterned print tracks.

The adjustment parameters may be the same misalignment (K) and angular stagger (θ) values as previously detected, or they can be values suitably modified based on the former, and correlated to the configuration of possible adjustment apparatuses in the screen printing chamber and/or screen printing system. In some embodiments, the adjustment parameters can be used to modify suitable printing parameters needed to carry out the subsequent printing operations, to obtain a correct alignment of the subsequent printing with the already deposited print tracks.

Some embodiments provide that determining the printing parameters is defined based on the first deviations as described above. In other embodiments, it is provided that the adjustment parameters allow for modifying the position of the screen-printing mask 102B, so as to dispose its distinctive elements 102C substantially aligned with the already deposited print tracks 252. Other embodiments provide that the adjustment parameters allow for determining possible actions to reposition the substrate 250 on the printing nest 131, in order to define the correct alignment of the print tracks 252 and the distinctive elements 102C of the screen-printing mask 102B.

According to one embodiment, the method for printing a pattern on a substrate includes the following steps: acquiring an image of at least one surface area of a substrate having a plurality of print tracks printed thereon; identifying a position of a print track portion on the plurality of print tracks with respect to at least one side of the substrate by means of the acquired image, wherein identifying the position of a print track portion on the plurality of print tracks includes identifying a distance between the print track portion and the at least one side of the substrate, wherein the at least one side of the substrate is perpendicular (including a tolerance of ± 10° in embodiments described herein) to the longitudinal axis of the print track portion; determining adjustment parameters by comparing the position of the print track portion with a position of a predefined print track, wherein the position of the print track portion is compared with a position of a predefined print track regarding a direction perpendicular to the longitudinal axis of the print track portion; and executing a subsequent printing operation based on the adjustment parameters.

According to embodiments herein, the step of comparing the position of the print track portion with a position of a predefined print track includes at least one element chosen from the following list: comparing the distance between the print track portion and the predefined print track in a direction perpendicular to the longitudinal axis of the print track portion (i.e. misalignment K) and comparing the angular stagger (θ) between the print track portion and the predefined print track. According to embodiments described herein, the predefined print track may be a previously deposited print track or a print track deposited on a previously processed substrate.

In embodiments described herein, identifying the distance of the print track portion with respect to at least one side of the substrate that is perpendicular to the longitudinal axis of the print track portion and determining adjustment parameters (e.g. angular stagger (θ) and misalignment (K) may be particularly advantageous because it enables a more precise alignment between a plurality of print tracks printed one on top of another in subsequent printing operations. In further embodiments it may also enable a more precise alignment between a plurality of print tracks printed on two, three or more different substrates.

### Experimental Examples/Trials

We shall now describe the parameters that the Applicants have used in experimental trials of printing substrates 250 using a multilayer printing pattern to form solar cells with selective emitters.

In particular, the experimental conditions were as follows: (i) a print head having about a 70° inclination; (ii) a print mask with about 78 apertures having a width of about 80 mm; (iii) a silver based conductive paste for depositing the print tracks 252; and (iv) printing in position mode with a print force, i.e., the force that the printing equipment exerts on the screen printing mask 102B during printing, of about 80 N.

Tests were performed on eight different substrates to print selective emitters. The substrates were subjected to a process of eliminating the solvents that could affect the measurements. The measurements were carried out on each of the substrates 250 at nine points having the same coordinates for each cell. The measurements were intended to detect any shift of one print track 252 with respect to a subsequent print track 252 deposited above the first track.

From the measurements made using the above described experimental conditions, a good alignment and overlapping of the print tracks was shown. In particular, it was shown that it is possible to obtain a shift of less than about 50 mm with respect to the median axes of the selective emitters, and of the silver print tracks deposited according to a pattern. This result was confirmed using four different printing nests 131.

In general, the greatest shifts detected (at one point a maximum shift of about 75 mm was detected) were due to the imperfect centering of the print mask and the selective emitters. It was shown, however, that even in the worst shift cases it is possible to obtain a good overlap on print tracks with a width of about 300 mm.

While the foregoing is directed to embodiments of the present invention, other and further embodiments of the invention may be devised without departing from the basic scope thereof, and the scope thereof is determined by the claims that follow.

## Claims

1. A method of printing a pattern on a substrate comprising:
acquiring an image of a surface area of the substrate having a plurality of print tracks printed thereon;
identifying a position of a print track portion on the plurality of print tracks with respect to at least one side of the substrate by means of the image;
determining adjustment parameters by comparing the position of the print track portion with a position of a predefined print track; and
executing a subsequent printing operation based on the adjustment parameters.

2. The method of claim 1, wherein identifying the position of the print track portion comprises determining a first distance and an angle of orientation of the print track portion with respect to the at least one side of the substrate.

3. The method according to any of the preceding claims, wherein identifying a position of a print track portion on the plurality of print tracks comprises identifying a position of at least two print track portions on the same print track and/or identifying a position of at least two print track portions on two different print tracks.

4. The method according to any of the preceding claims, wherein the comparing is configured to determine first deviations between the print track portion and the predefined print track, preferably wherein the comparing the position is configured to determine printing parameters based on the first deviations.

5. The method according to any of the preceding claims, wherein the comparing the position is configured to assess a position of the print tracks based on the position of print track portion.

6. The method according to any of the preceding claims, wherein comparing the position of the print track portion with a position of a predefined print track includes comparing the print track portion with a position of a predefined print track regarding a direction perpendicular to the longitudinal axis of the print track portion, preferably wherein comparing the position of the print track portion with a position of a predefined print track includes at least one of the elements chosen from the following list:
comparing the distance between the print track portion and the predefined print track in a direction perpendicular to the longitudinal axis of the print track portion and comparing the angular stagger between the print track portion and the predefined print track.

7. The method according to any of the preceding claims, wherein the predefined print track is a previously deposited print track or a print track deposited on a previously processed substrate.

8. The method according to any of the preceding claims, wherein the image is optically acquired.

9. The method according to any of the preceding claims, wherein acquiring the image of the surface area comprises:
acquiring respective images of a plurality of the surface areas, wherein the acquiring respective images is configured to determine a position and an orientation of at least one print track portion present on each of the surface areas.

10. The method according to any of the preceding claims, wherein executing a subsequent printing operation comprises depositing a further layer of print tracks on top of the plurality of print tracks already present on the substrate.

11. The method according to any of the preceding claims, wherein the substrate is a monocast silicon substrate.

12. The method according to any of the preceding claims, wherein identifying the position of a print track portion on the plurality of print tracks with respect to at least one side of the substrate includes identifying a distance between the print track portion and the at least one side of the substrate, wherein the at least one side of the substrate is perpendicular to the longitudinal axis of the print track portion.

13. An apparatus for printing on a substrate, comprising:
at least one inspection unit configured to acquire an image of a surface area of the substrate having a plurality of print tracks printed thereon; and
a computer readable medium containing instructions for a processor to execute a method for printing a pattern on the substrate comprising:
identifying a position of a print track portion of the plurality of print tracks with respect to at least one side of the substrate by means of the image;
determining adjustment parameters by comparing the position of the print track portion with a position of a predefined print track; and
executing a subsequent printing operation based on the adjustment parameters.

14. The apparatus of claim 13, wherein the at least one inspection unit comprises at least one camera configured to acquire the image of the surface area of the substrate.

15. The apparatus according to claim 13 or 14, wherein the method for printing the pattern on the substrate is any claim from 1 to 12 using said apparatus.
